# EUROPÄISCHE PATENTSCHRIFT

(11) **EP 3 984 338 B1**
(45) Veröffentlichungstag und Bekanntmachung des Hinweises auf die Patenterteilung: **18.03.2026**
(21) Anmeldenummer: 20771440.3
(22) Anmeldetag: 21.08.2020
(51) Int. Cl.: H05K 5/06, H05K 7/20

(54) **TRÄGER FÜR ELEKTRISCHE BAUELEMENTE**
SUPPORT FOR ELECTRICAL COMPONENTS
SUPPORT POUR COMPOSANTS ÉLECTRIQUES

(30) Priorität: 25.09.2019 EP 19199594
(43) Veröffentlichungstag der Anmeldung: 20.04.2022
(73) Patentinhaber: Siemens Aktiengesellschaft, 80333 München (DE)
(72) Erfinder: KAPPAUF, Daniel, 91322 Gräfenberg (DE); NAMYSLO, Lutz, 91353 Hausen (DE)
(74) Vertreter: Siemens Patent Attorneys
(86) Internationale Anmeldenummer: PCT/EP2020/073471
(87) Internationale Veröffentlichungsnummer: WO 2021/058212

(56) Entgegenhaltungen:
- EP-A2- 1 753 025
- EP-B1- 1 753 025
- WO-A1-2014/132424
- US-A- 5 131 456
- US-A- 5 138 521
- US-A1- 2007 134 951
- US-A1- 2010 091 461
- US-A1- 2014 029 201
- US-B2- 9 730 362

## Beschreibung

Die Erfindung betrifft einen Träger für wenigstens ein elektrisches Bauelement, ein Verfahren zur Herstellung eines derartigen Trägers sowie ein Elektronikmodul.

Die Fertigung von Elektronikmodulen mit Leistungshalbleitern wie IGBT (Bipolartransistoren mit isolierter Gate-Elektrode, engl. insulated-gate bipolar transistors) oder MOSFET (Metall-Oxid-Halbleiter-Feldeffekttransistoren, engl. metaloxide-semiconductor field-effect transistors) ist aufwändig und kostspielig. Um die hohen Isolationsanforderungen bei solchen Elektronikmodulen zu erfüllen, werden die Halbleiterchips und Bonddrähte mit einer Vergussmasse, beispielsweise einer silikonbasierten Weichvergussmasse, bedeckt. Die Vergussmasse verhindert zusätzlich das Eindringen von Feuchtigkeit und eine Korrosion der Bauteile. Während des Vergießens ist die Vergussmasse sehr dünnflüssig. Um eine gute Benetzung zu erreichen und Blasenbildung zu vermeiden wird der Verguss mit einem geringen Unterdruck durchgeführt. Ein Ausfließen der Vergussmasse während des Vergussprozesses und der Aushärtephase wird durch ein Modulgehäuse verhindert. Das Modulgehäuse muss dafür eine hohe Dichtigkeit in sich und zu einer Bodenplatte des Elektronikmoduls aufweisen. Deshalb werden die Modulgehäuseteile miteinander und mit der Bodenplatte durch einen hochelastischen Kleber verbunden. Der Klebeprozess und der Weichverguss erfordern mehrere Aufheizvorgänge zum Vortrocknen und Aushärten des Klebers und der Vergussmasse, welche hohe Fertigungsprozesszeiten verursachen. Ferner erfordert die Entwicklung eines Modulgehäuses einen relativ hohen Entwicklungsaufwand. Zusätzlich entstehen hohe Investitionskosten für Spritzgusswerkzeuge und eine Maschine zur automatischen Pin-Bestückung der Elektronikmodule. Auch die Werkzeugentwicklung für die Herstellung der Bodenplatte erfordert mehrere Iterationsschleifen.

Die Offenlegungsschrift US 5138 521 A beschreibt eine elektronische Baugruppe umfassend eine Gehäusekonstruktion, die einen ebenen Basisabschnitt umfasst, eine Rippe, die von dem ebenen Basisabschnitt der Gehäusekonstruktion absteht, und ein wärmeerzeugendes Element, das fest an dem ebenen Basisabschnitt der Gehäusekonstruktion angebracht ist.

Die Offenlegungsschrift US 2014/029201 A1 beschreibt ein Leistungsmodul umfassend einen Leiterrahmen, mindestens ein erstes elektronisches Bauteil, das auf dem Leiterrahmen montiert ist, und ein Isolierelement, das auf einer ersten Oberfläche des ersten elektronischen Bauteils angeordnet ist und eine Durchgangselektrode aufweist, die mit dem ersten elektronischen Bauteil verbunden ist.

Die Offenlegungsschrift WO 2014/132424 A1 beschreibt ein elektronisches Modul mit einem ersten Funktionsteil, der ein Substrat mit einem daran befestigten elektronischen Teil aufweist, einem zweiten Funktionsteil, der ein Substrat mit einem daran befestigten elektronischen Teil aufweist und elektrisch mit dem ersten Funktionsteil verbunden ist und einem Kühlkörper, der den ersten Funktionsteil und den zweiten Funktionsteil kühlt. Der Kühlkörper umfasst eine Grundplatte, an der im Inneren ein Speicherteil vorgesehen ist. Das erste Funktionsteil ist in dem Speicherteil untergebracht, so dass das erste Substrat mit einer Innenwand des Speicherteils der Grundplatte in Kontakt steht. Das zweite Funktionsteil ist so auf der Grundplatte befestigt, dass das zweite Substrat mit einer Hauptoberfläche der Grundplatte in Kontakt steht.

Die Offenlegungsschrift EP 1 753 025 A2 beschreibt ein elektrisch isolierendes Substrat, das in einem Gehäuse angeordnet ist. Das Substrat besteht aus einem Isolierstoffkörper und elektrisch isolierten metallischen Anschlussbahnen. Eine Leistungshalbleitereinheit ist mit einer Anschlusseinheit versehen. Eine Grundplatte hat einen wannenförmigen Teil, der das Substrat so umschließt, dass die Seitenwände der Grundplatte eine größere Höhe aufweisen als das Höhenniveau einer Vergussmasse im Inneren der Grundplatte, wobei die Vergussmasse aus Silikonkautschuk besteht und die Platte durch eine Klebeverbindung am Substrat befestigt ist.

Der Erfindung liegt die Aufgabe zugrunde, die Fertigung von Elektronikmodulen, insbesondere von Elektronikmodulen mit Leistungshalbleitern, zu vereinfachen und deren Kosten zu reduzieren.

Die Aufgabe wird erfindungsgemäß durch einen Träger für wenigstens ein elektrisches Bauelement mit den Merkmalen des Anspruchs 1, ein Verfahren zum Herstellen eines derartigen Trägers mit den Merkmalen des Anspruchs 12 und ein Elektronikmodul mit den Merkmalen des Anspruchs 13 gelöst.

Vorteilhafte Ausgestaltungen der Erfindung sind Gegenstand der Unteransprüche.

Ein erfindungsgemäßer Träger für wenigstens ein elektrisches Bauelement umfasst einen Kühlkörper mit einer Kühlkörperoberfläche und zwei von der Kühlkörperoberfläche abstehenden, sich gegenüberliegenden Seitenwänden, zwei auf der Kühlkörperoberfläche aufliegende, voneinander beabstandete Abdichtblöcke, die sich jeweils zwischen den beiden Seitenwänden erstrecken und an jeder der beiden Seitenwände anliegen, und eine auf der Kühlkörperoberfläche zwischen den beiden Abdichtblöcken angeordnete Trägerstruktur für das wenigstens eine elektrische Bauelement.

Ein erfindungsgemäßer Träger dient dazu, die Komplexität von Elektronikmodulen zu reduzieren, indem Funktionen von Bauteilen herkömmlicher Elektronikmodule von dem Träger übernommen werden und dadurch Bauteile eingespart oder vereinfacht werden. Dadurch wird die Fertigung eines Elektronikmoduls vereinfacht und Kosten der Fertigung werden reduziert. Insbesondere ermöglicht die Erfindung die Fertigung eines Elektronikmoduls mit Leistungshalbleitern ohne ein komplexes Modulgehäuse, das ein Ausfließen von Vergussmasse zur Isolierung der Leistungshalbleiter verhindert. Die Funktion des Modulgehäuses wird von den Seitenwänden und den Abdichtblöcken des erfindungsgemäßen Trägers übernommen, die ein Ausfließen von Vergussmasse vor deren Aushärtung verhindern. Insbesondere entfällt dadurch das Abdichten eines Modulgehäuses durch einen aufwändigen und langwierigen Klebeprozess mit einem auf die verwendeten Materialien abgestimmten Kleber. Ferner ist keine Bodenplatte für das Elektronikmodul mehr erforderlich, da deren Funktion von dem Kühlkörper übernommen wird. Die direkt auf der Kühlkörperoberfläche angeordnete Trägerstruktur ermöglicht eine verbesserte Entwärmung auf der Trägerstruktur angeordneter elektrischer Bauelemente und ermöglicht dadurch eine höhere Belastbarkeit der elektrischen Bauelemente und/oder eine verlängerte Lebensdauer der elektrischen Bauelemente.

Ferner weist der Kühlkörper einen Grundkörper und eine die Kühlkörperoberfläche ausbildende Wärmespreizschicht, beispielsweise eine Kupferschicht, auf. Durch die zwischen dem Grundkörper und der Trägerstruktur angeordnete Wärmespreizschicht wird die Entwärmung der auf der Trägerstruktur angeordneten elektrischen Bauelemente weiter verbessert.

Darüber hinaus ist der Grundkörper aus Aluminium gefertigt, wobei die Wärmespreizschicht als eine Kupferschicht ausgeführt ist und wobei die Kupferschicht gemeinsam mit dem Grundkörper durch Stranggießen hergestellt ist oder wobei die Kupferschicht additiv, insbesondere durch Kaltgasspritzen, auf die Grundkörperoberfläche (23) aufgebracht ist. Aluminium eignet sich aufgrund seiner hohen Wärmeleitfähigkeit und relativ geringen Kosten als Material des Grundkörpers. Durch die, insbesondere im Vergleich zu Aluminium, höhere Wärmeleitfähigkeit der Kupferschicht wird die Entwärmung der auf der Trägerstruktur angeordneten elektrischen Bauelemente weiter verbessert. Eine gemeinsame Herstellung der Kupferschicht mit dem Grundkörper durch Stranggießen ist kostengünstig. Durch das additive Aufbringen der Kupferschicht, insbesondere durch Kaltgasspritzen, wird eine stoffschlüssige Verbindung zwischen der Kupferschicht und dem Kühlkörper hergestellt, was zu einem verbesserten Wärmeübergang führt.

Bei einer weiteren Ausgestaltung der Erfindung ist jeder Abdichtblock durch wenigstens eine Schraubverbindung mit dem Kühlkörper kraftschlüssig verbindbar. Dies ermöglicht eine einfache Montage und eine flexible Positionierbarkeit der Abdichtblöcke.

Bei einer weiteren Ausgestaltung der Erfindung ist jeder Abdichtblock mit dem Kühlkörper durch wenigstens eine Nut-Feder-Verbindung formschlüssig verbunden. Durch Nut-FederVerbindungen kann die ein Ausfließen von Vergussemasse verhindernde Abdichtfunktion der Abdichtblöcke vorteilhaft verbessert werden.

Bei einer weiteren Ausgestaltung der Erfindung ist an wenigstens einem Abdichtblock wenigstens eine elektrisch leitfähige Anschlusslasche für einen elektrischen Leistungsanschluss angeordnet. Dadurch kann ein Abdichtblock neben seiner Abdichtfunktion auch eine Tragfunktion für wenigstens einen elektrischen Leistungsanschluss zur Versorgung der elektrischen Bauelemente mit Gleich- oder Wechselstrom erfüllen.

Bei einer weiteren Ausgestaltung der Erfindung sind die Abdichtblöcke aus Kunststoff gefertigt. Dies ermöglicht vorteilhaft eine einfache und kostengünstige Herstellung der Abdichtblöcke, beispielsweise durch Spritzgießen mit einem einfachen Spritzgießwerkzeug.

Bei einer weiteren Ausgestaltung weist zumindest einer der Abdichtblöcke auf einer der Kühlkörperoberfläche zugewandten Seite eine Sicke auf, in welcher eine Abdichtvorrichtung angeordnet ist. Beispielsweise ist die Sicke eine zylindersegmentförmige Ausnehmung, welche insbesondere orthogonal zu den Seitenwänden des Kühlkörpers verläuft. Insbesondere wird die Abdichtvorrichtung im Bereich der Sicke zusammengedrückt, sodass eine verbesserte Abdichtfunktion des zumindest einen Abdichtblocks erreicht wird.

Bei einer weiteren Ausgestaltung weist die Abdichtvorrichtung eine adhäsive Verbindung mit der Kühlkörperoberfläche und/oder mit dem zumindest einen Abdichtblock aufweist. Eine derartige Abdichtvorrichtung ist beispielsweise als Kleberaupe ausgeführt, wobei die adhäsive Verbindung zu einer weiteren Verbesserung der Abdichtfunktion führt.

Bei einer weiteren Ausgestaltung der Erfindung weist die Trägerstruktur ein abseitig der Kühlkörperoberfläche mit einer Kupferstruktur beschichtetes Keramiksubstrat auf. Die Trägerstruktur ist damit eine so genannte DCB-Struktur (DCB = direct bonded copper) mit einer Kupferstruktur zum elektrischen Verbinden, Aufbringen und Entwärmen auf der Trägerstruktur angeordneter elektrischer Bauelemente.

Bei einer weiteren Ausgestaltung der Erfindung weist der Träger auf der Trägerstruktur angeordnete Anschlusskontakte auf, die von der Trägerstruktur abseitig der Kühlkörperoberfläche abstehen. Dies ermöglicht eine Kontaktierung auf der Trägerstruktur angeordneter elektrischer Bauelemente über die Anschlusskontakte, beispielsweise um elektrische Bauelemente anzusteuern. Durch die direkte Positionierung der Anschlusskontakte auf der Trägerstruktur ist keine separate Maschine für eine automatische Pin-Montage mehr notwendig, die hohe Investitionskosten erfordert. Die Platzierung der Anschlusskontakte kann mittels eines in der Regel ohnehin vorhandenen Bestückungsautomaten (so genannter Pick-and-Place Automat) erfolgen. Die direkte Positionierung der Anschlusskontakte auf der Trägerstruktur (und nicht etwa am Rand des Moduls) verkürzt außerdem vorteilhaft die Bonddrahtverbindungen und reduziert damit parasitäre Induktivitäten und Widerstände, was sich vorteilhaft auf die Schaltüberspannung und die elektromagnetische Verträglichkeit der Schaltungsanordnung auswirkt.

Bei einer Weitergestaltung der vorgenannten Ausgestaltung der Erfindung weist der Träger einen Deckel auf, der mit dem Kühlkörper lösbar verbindbar ist, beispielsweise durch wenigstens eine Rastverbindung und/oder wenigstens eine Schraubverbindung, und Deckelöffnungen für die Anschlusskontakte aufweist, um die Anschlusskontakte zu stabilisieren. Der Deckel dient lediglich zum Stabilisieren der Anschlusskontakte gegen ein seitliches Abknicken und hält die Anschlusskontakte somit in ihrer Position. Insbesondere hat der Deckel keine Abdichtfunktion und ist somit ein einfach herstellbares und montierbares Bauteil.

Bei dem erfindungsgemäßen Verfahren zum Herstellen eines erfindungsgemäßen Trägers wird der Kühlkörper durch Stranggießen oder durch Stranggießen mit anschließendem additiven Aufbringen einer die Kühlkörperoberfläche bildenden Wärmespreizschicht hergestellt, die Abdichtblöcke werden durch Spritzgießen hergestellt, und die Trägerstruktur wird durch Löten oder Sintern auf die Kühlkörperoberfläche aufgebracht. Das erfindungsgemäße Verfahren ermöglicht vorteilhaft eine einfache und kostengünstige Herstellung eines erfindungsgemäßen Trägers.

Ein erfindungsgemäßes Elektronikmodul umfasst einen erfindungsgemäßen Träger, wenigstens ein auf der Trägerstruktur des Trägers angeordnetes elektrisches Bauelement und eine Vergussmasse, beispielsweise eine silikonbasierte Weichvergussmasse, die die Trägerstruktur und das wenigstens eine elektrische Bauelement bedeckt. Beispielsweise kann wenigstens ein elektrisches Bauelement ein Leistungshalbleiter-Bauelement, insbesondere ein IGBT oder MOSFET, sein. Da ein erfindungsgemäßes Elektronikmodul einen erfindungsgemäßen Träger für die elektrischen Bauelemente des Elektronikmoduls aufweist, entsprechen die Vorteile eines erfindungsgemäßen Elektronikmoduls den oben genannten Vorteilen eines erfindungsgemäßen Trägers.

Bei einer weiteren Ausgestaltung der Erfindung umfasst das Elektronikmodul einen Kühlbalken, welcher Ausnehmungen zur Aufnahme von Kühlrippen des Kühlkörpers aufweist, wobei der Kühlkörper über die Kühlrippen mit den Ausnehmungen des Kühlbalkens verbunden ist. Eine derartige Anordnung führt zu einer Kühlkörperverlängerung, die eine Entwärmung der auf der Trägerstruktur angeordneten elektrischen Bauelemente verbessert. Da das Elektronikmodul, beispielsweise beim Löten in einem Lötofen, zunächst ohne den Kühlbalken bearbeitet wird, wird eine thermische Masse des zu lötenden Bauteils reduziert, was zu einer Zeitersparnis und Kostenersparnis während des Herstellungsprozesses führt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 eine perspektivische Darstellung eines ersten Ausführungsbeispiels eines Elektronikmoduls ohne Deckel,
FIG 2 eine perspektivische Darstellung des in FIG 1 gezeigten Elektronikmoduls mit Deckel,
FIG 3 eine Schnittdarstellung des Kühlkörpers des in FIG 1 gezeigten Elektronikmoduls,
FIG 4 eine perspektivische Schnittdarstellung zweier Elektronikmodule gemäß einem zweiten Ausführungsbeispiel.

Einander entsprechende Teile sind in den Figuren mit denselben Bezugszeichen versehen.

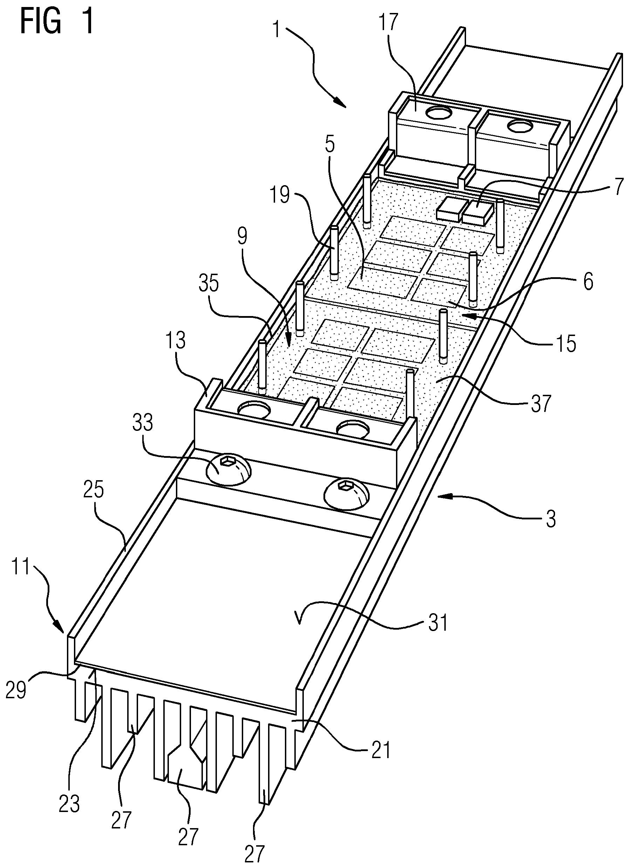

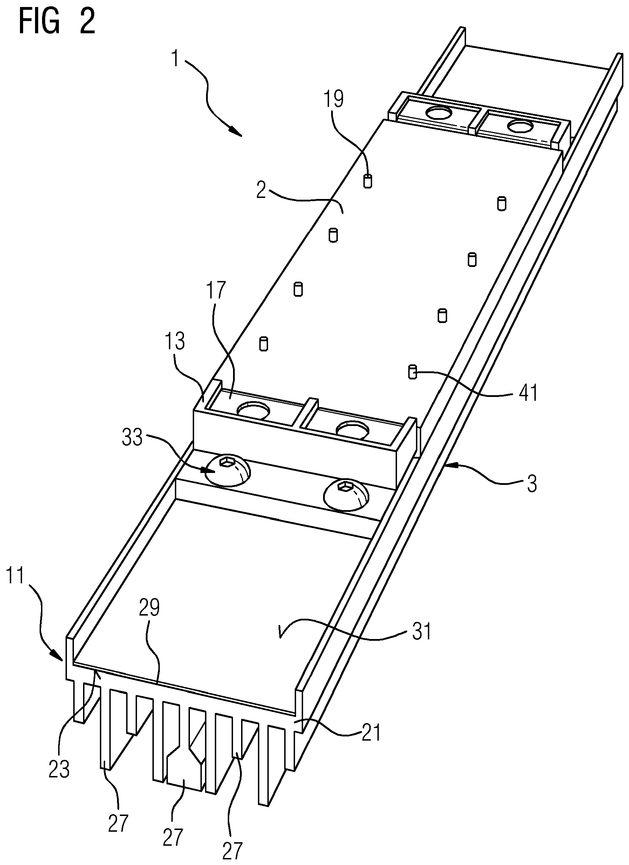

Die Figuren 1 und 2 (FIG 1 und FIG 2) zeigen jeweils eine perspektivische Darstellung eines ersten Ausführungsbeispiels eines erfindungsgemäßen Elektronikmoduls 1. Dabei zeigt Figur 1 das Elektronikmodul 1 ohne Deckel 2 und Figur 2 zeigt das Elektronikmodul 1 mit Deckel 2. Das Elektronikmodul 1 umfasst einen erfindungsgemäßen Träger 3, elektrische Bauelemente 5 bis 7 und eine Vergussmasse 9.

Der Träger 3 umfasst den Deckel 2, einen Kühlkörper 11, zwei Abdichtblöcke 13, eine Trägerstruktur 15, Anschlusslaschen 17 und pinförmige Anschlusskontakte 19.

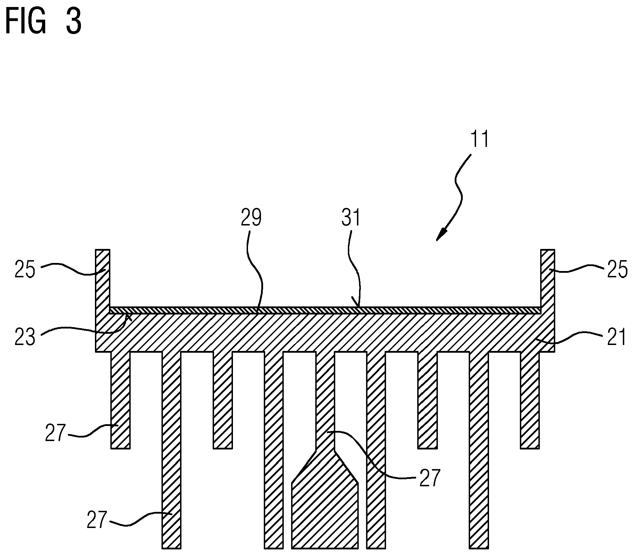

Figur 3 (FIG 3) zeigt eine Schnittdarstellung des Kühlkörpers 11. Der Kühlkörper 11 weist einen Grundkörper 21 auf, der oberseitig eine plane Grundkörperoberfläche 23 und zwei von der Grundkörperoberfläche 23 abstehende, sich gegenüberliegende Seitenwände 25 und unterseitig mehrere Kühlrippen 27 aufweist. Die Grundkörperoberfläche 23 ist mit einer Wärmespreizschicht 29 beschichtet, die eine plane Kühlkörperoberfläche 31 ausbildet. Beispielsweise ist der Grundkörper 21 aus Aluminium durch Stranggießen hergestellt. Die Wärmespreizschicht 29 ist beispielsweise eine Kupferschicht, die beispielsweise gemeinsam mit dem Grundkörper 21 durch Stranggießen hergestellt wird oder additiv, beispielsweise durch Kaltgasspritzen, auf die Grundkörperoberfläche 23 aufgebracht wird. In dem gezeigten Ausführungsbeispiel stehen die Seitenwände 25 senkrecht von der Grundkörperoberfläche 23 ab. In anderen Ausführungsbeispielen können die Seitenwände 25 schräg von der Grundkörperoberfläche 23 abstehen und/oder die Seitenwände 25 können mit der Grundkörperoberfläche 23 in den Übergangsbereichen zwischen den Seitenwänden 25 und der Grundkörperoberfläche 23 ein abgerundetes Profil bilden.

Die beiden Abdichtblöcke 13 sind voneinander beabstandet auf der Kühlkörperoberfläche 31 angeordnet, erstrecken sich jeweils zwischen den beiden Seitenwänden 25 und liegen an jeder der beiden Seitenwände 25 und an der Kühlkörperoberfläche 31 abdichtend an. Jeder Abdichtblock 13 ist durch zwei Schraubverbindungen 33 mit dem Kühlkörper 11 kraftschlüssig verbunden. Zusätzlich kann jeder Abdichtblock 13 durch wenigstens eine (nicht dargestellte) Nut-Feder-Verbindung mit dem Kühlkörper 11 formschlüssig verbunden sein. Beispielsweise werden die Abdichtblöcke 13 durch Spritzgießen aus Kunststoff gefertigt.

Die Trägerstruktur 15 ist auf der Kühlkörperoberfläche 31 zwischen den beiden Abdichtblöcken 13 angeordnet. Die Trägerstruktur 15 weist ein auf der Kühlkörperoberfläche 31 aufliegendes Keramiksubstrat 35 auf, dessen von der Kühlkörperoberfläche 31 abgewandte Seite mit einer Kupferstruktur 37 beschichtet ist, die Leiterbahnen und Kontaktflächen zum elektrischen Verbinden, Aufbringen und Entwärmen der elektrischen Bauelemente 5 bis 7 und der Anschlusskontakte 19 bildet. Die Trägerstruktur 15 ist eine so genannte DCB-Struktur mit dem Keramiksubstrat 35 als DCB-Substrat. Die Trägerstruktur 15 wird durch Löten oder Sintern auf die Kühlkörperoberfläche 31 aufgebracht.

Die Anschlusslaschen 17 bilden Leistungsanschlüsse des Elektronikmoduls 1 zur Versorgung der elektrischen Bauelemente 5 bis 7 mit Gleichstrom und/oder Wechselstrom. Jede Anschlusslasche 17 ist an einem Abdichtblock 13 angeordnet und stufenartig ausgebildet. In alternativen Ausführungsbeispielen können die Anschlusslaschen 17 auch entfallen und die Leistungsanschlüsse von pinförmigen Anschlusskontakten 19 gebildet werden, insbesondere wenn über die Leistungsanschlüsse relativ geringe Ströme (beispielsweise mit Stromstärken unterhalb von 100 A) fließen.

Die Anschlusskontakte 19 umfassen beispielsweise Steueranschlüsse zum Ansteuern elektrischer Bauelemente 5 bis 7. Die Anschlusskontakte 19 sind auf einer von der Kühlkörperoberfläche 31 abgewandten Seite der Trägerstruktur 15 angeordnet und werden beispielsweise durch Ultraschallschweißen oder Löten mit der Kupferstruktur 37 der Trägerstruktur 15 verbunden. In anderen Ausführungsbeispielen können anstelle pinförmiger Anschlusskontakte 19 planar ausgeführte Anschlusskontakte 19 vorgesehen sein.

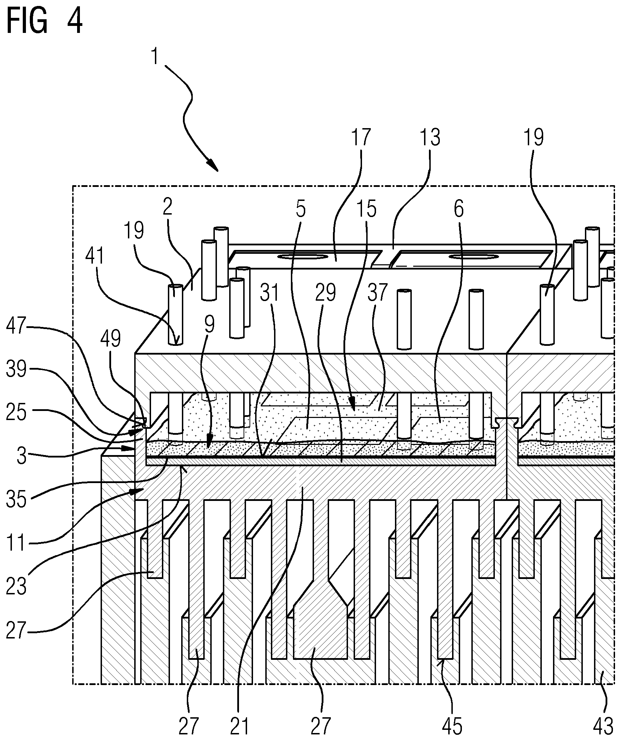

Der Deckel 2 ist mit dem Kühlkörper 11 lösbar verbunden, beispielsweise über Rastverbindungen 39 (siehe Figur 4) und/oder über Schraubverbindungen. Der Deckel 2 weist Deckelöffnungen 41 für die Anschlusskontakte 19 auf. Jeder Anschlusskontakt 19 wird durch eine Deckelöffnung 41 geführt, die den Anschlusskontakt 19 stabilisiert, indem sie ein seitliches Abknicken des Anschlusskontakts 19 verhindert und den Anschlusskontakt 19 somit in seiner Position hält. Der Deckel 2 ist eine optionale Komponente des Trägers 3 und dient lediglich der Stabilisierung der Anschlusskontakte 19. Insbesondere bei Ausführungsbeispielen mit planaren statt pinförmigen Anschlusskontakten 19 kann der Deckel 2 daher entfallen.

Die elektrischen Bauelemente 5 bis 7 sind auf der Trägerstruktur 15 angeordnet. Elektrische Bauelemente 5 bis 7 können beispielsweise Leistungshalbleiter-Bauelemente wie ein IGBT oder MOSFET sein.

Die Vergussmasse 9 ist beispielsweise eine silikonbasierte Weichvergussmasse und bedeckt die elektrischen Bauelemente 5 bis 7 und die Trägerstruktur 15. Die Seitenwände 25 und die Abdichtblöcke 13 verhindern das Ausfließen flüssiger Vergussmasse 9 nach dem Aufbringen auf die elektrischen Bauelemente 5 bis 7 und die Trägerstruktur 15 vor dem Aushärten der Vergussmasse 9.

Figur 4 (FIG 4) zeigt eine perspektivische Schnittdarstellung zweier Elektronikmodule 1 gemäß einem zweiten Ausführungsbeispiel. Die Elektronikmodule 1 sind nebeneinander über einem Kühlbalken 43 angeordnet, der Ausnehmungen 45 für die Kühlrippen 27 der Kühlkörper 11 der Elektronikmodule 1 aufweist. Die Elektronikmodule 1 unterscheiden sich von dem in den Figuren 1 und 2 gezeigten Elektronikmodul 1 lediglich durch die Anordnung elektrischer Bauelemente 5 bis 7 und Anschlusskontakte 19 sowie die Ausbildung der Kupferstruktur 37. Figur 4 zeigt die Ausführung von Rastverbindungen 39 zum Verbinden des Deckels 2 mit dem Kühlkörper 11 eines Elektronikmoduls 1. Jede Rastverbindung 39 wird durch eine Rastnut 47 in einer Seitenwand 25 und eine in die Rastnut 47 eingreifende Rastfeder 49 des Deckels 2 gebildet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, solange diese Variationen unter die beigefügten Ansprüche fallen.

## Patentansprüche

1. Träger (3) für wenigstens ein elektrisches Bauelement (5 bis 7), der Träger (3) umfassend
- einen Kühlkörper (11) mit einer Kühlkörperoberfläche (31) und zwei von der Kühlkörperoberfläche (31) abstehenden, sich gegenüberliegenden Seitenwänden (25),
- zwei auf der Kühlkörperoberfläche (31) aufliegende, voneinander beabstandete Abdichtblöcke (13), die sich jeweils zwischen den beiden Seitenwänden (25) erstrecken und an jeder der beiden Seitenwände (25) anliegen, und
- eine auf der Kühlkörperoberfläche (31) zwischen den beiden Abdichtblöcken (13) angeordnete Trägerstruktur (15) für das wenigstens eine elektrische Bauelement (5 bis 7),
wobei der Kühlkörper (11) einen Grundkörper (21) und eine die Kühlkörperoberfläche (31) ausbildende Wärmespreizschicht (29) aufweist,
wobei der Grundkörper (21) aus Aluminium gefertigt ist, wobei die Wärmespreizschicht (29) als eine Kupferschicht ausgeführt ist,
**dadurch gekennzeichnet, dass**
die Kupferschicht gemeinsam mit dem Grundkörper (21) durch Stranggießen hergestellt ist oder
dass die Kupferschicht additiv durch Kaltgasspritzen auf die Grundkörperoberfläche (23) aufgebracht ist.

2. Träger (3) nach Anspruch 1, wobei jeder Abdichtblock (13) durch wenigstens eine Schraubverbindung (33) mit dem Kühlkörper (11) kraftschlüssig verbindbar ist.

3. Träger (3) nach einem der vorhergehenden Ansprüche, wobei jeder Abdichtblock (13) mit dem Kühlkörper (11) durch wenigstens eine Nut-Feder-Verbindung formschlüssig verbunden ist.

4. Träger (3) nach einem der vorhergehenden Ansprüche, wobei an wenigstens einem Abdichtblock (13) wenigstens eine elektrisch leitfähige Anschlusslasche (17) für einen elektrischen Leistungsanschluss angeordnet ist.

5. Träger (3) nach einem der vorhergehenden Ansprüche, wobei die Abdichtblöcke (13) aus Kunststoff gefertigt sind.

6. Träger (3) nach einem der vorhergehenden Ansprüche, wobei zumindest einer der Abdichtblöcke (13) auf einer der Kühlkörperoberfläche (31) zugewandten Seite eine, insbesondere orthogonal zu den Seitenwänden (25) Sicke aufweist, in welcher eine Abdichtvorrichtung angeordnet ist.

7. Träger (3) nach Anspruch 6,
wobei die Abdichtvorrichtung eine adhäsive Verbindung mit der Kühlkörperoberfläche (31) und/oder mit dem zumindest einen Abdichtblock (13) aufweist.

8. Träger (3) nach einem der vorhergehenden Ansprüche, wobei die Trägerstruktur (15) ein abseitig der Kühlkörperoberfläche (31) mit einer Kupferstruktur (37) beschichtetes Keramiksubstrat (35) aufweist.

9. Träger (3) nach einem der vorhergehenden Ansprüche mit auf der Trägerstruktur (15) angeordneten Anschlusskontakten (19), die von der Trägerstruktur (15) abseitig der Kühlkörperoberfläche (31) abstehen.

10. Träger (3) nach Anspruch 9 mit einem Deckel (2), der mit dem Kühlkörper (11) lösbar verbindbar ist und Deckelöffnungen (41) für die Anschlusskontakte (19) aufweist, um die Anschlusskontakte (19) zu stabilisieren.

11. Träger (3) nach Anspruch 10, wobei der Deckel (2) über wenigstens eine Rastverbindung (39) und/oder wenigstens eine Schraubverbindung mit dem Kühlkörper (11) verbindbar ist.

12. Verfahren zum Herstellen eines Trägers (3) nach einem der vorhergehenden Ansprüche, wobei
- der Kühlkörper (11) durch Stranggießen oder durch Stranggießen mit anschließendem additiven Aufbringen einer die Kühlkörperoberfläche (31) bildenden Wärmespreizschicht (29) hergestellt wird,
- die Abdichtblöcke (13) durch Spritzgießen hergestellt werden und
- die Trägerstruktur (15) durch Löten oder Sintern auf die Kühlkörperoberfläche (31) aufgebracht wird.

13. Elektronikmodul (1), umfassend
- einen Träger (3) nach einem der Ansprüche 1 bis 11,
- wenigstens ein auf der Trägerstruktur (15) des Trägers (3) angeordnetes elektrisches Bauelement (5 bis 7) und
- eine Vergussmasse (9), beispielsweise eine silikonbasierte Weichvergussmasse, die die Trägerstruktur (15) und das wenigstens eine elektrische Bauelement (5 bis 7) bedeckt.

14. Elektronikmodul (1) nach Anspruch 13, wobei wenigstens ein elektrisches Bauelement (5 bis 7) ein Leistungshalbleiter-Bauelement, insbesondere ein Bipolartransistor mit isolierter Gate-Elektrode, ist.

15. Elektronikmodul (1) nach einem der Ansprüche 13 oder 14, umfassend einen Kühlbalken (43), welcher Ausnehmungen (45) zur Aufnahme von Kühlrippen (27) des Kühlkörpers (11) aufweist,
wobei der Kühlkörper (11) über die Kühlrippen (27) mit den Ausnehmungen (45) des Kühlbalkens (43) verbunden ist.

## Claims

1. Support (3) for at least one electrical component (5 to 7), the support (3) comprising
- a heat sink (11) having a heat sink surface (31) and two opposing lateral walls (25) protruding from the heat sink surface (31),
- two spaced-apart sealing blocks (13) lying on the heat sink surface (31), each extending between the two lateral walls (25) and being in contact with each of the two lateral walls (25), and
- a support structure (15) for the at least one electrical component (5 to 7) arranged on the heat sink surface (31) between the two sealing blocks (13),
wherein the heat sink (11) has a base body (21) and a heat spreading layer (29) forming the heat sink surface (31), wherein the base body (21) is manufactured from aluminium, wherein the heat spreading layer (29) is executed as a copper layer,
**characterised in that**
the copper layer is produced together with the base body (21) by means of continuous casting or
the copper layer is applied additively by means of cold gas spraying to the base body surface (23).

2. Support (3) according to claim 1, wherein each sealing block (13) can be non-positively connected to the heat sink (11) by at least one screw connection (33).

3. Support (3) according to one of the preceding claims, wherein each sealing block (13) is positively connected to the heat sink (11) by at least one tongue-and-groove connection.

4. Support (3) according to one of the preceding claims, wherein at least one electrically conductive connection lug (17) for an electrical power connection is arranged on at least one sealing block (13).

5. Support (3) according to one of the preceding claims, wherein the sealing blocks (13) are manufactured from plastic.

6. Support (3) according to one of the preceding claims, wherein at least one of the sealing blocks (13) has a bead on a side facing the heat sink surface (31), in particular orthogonal to the lateral walls (25), in which a sealing apparatus is arranged.

7. Support (3) according to claim 6,
wherein the sealing apparatus has an adhesive connection with the heat sink surface (31) and/or with the at least one sealing block (13).

8. Support (3) according to one of the preceding claims, wherein the support structure (15) has a ceramic substrate (35) coated with a copper structure (37) on the outside of the heat sink surface (31).

9. Support (3) according to one of the preceding claims having connection contacts (19) arranged on the support structure (15) which protrude from the support structure (15) on the outside of the heat sink surface (31).

10. Support (3) according to claim 9, having a cover (2) which can be detachably connected to the heat sink (11) and has cover openings (41) for the connection contacts (19) in order to stabilise the connection contact (19).

11. Support (3) according to claim 10, wherein the cover (2) can be connected to the heat sink (11) via at least one latching connection (39) and/or at least one screw connection.

12. Method for producing a support (3) according to one of the preceding claims, wherein
- the heat sink (11) is produced by means of continuous casting or by means of continuous casting with subsequent additive application of a heat spreading layer (29) forming the heat sink surface (31),
- the sealing blocks (13) are produced by injection moulding and
- the support structure (15) is applied to the heat sink surface (31) by means of soldering or sintering.

13. Electronics module (1), comprising
- a support (3) according to one of claims 1 to 11,
- at least one electrical component (5 to 7) arranged on the support structure (15) of the support (3) and
- a casting compound (9), for example, a silicon-based soft casting compound which covers the support structure (15) and the at least one electrical component (5 to 7).

14. Electronics module (1) according to claim 13, wherein at least one electrical component (5 to 7) is a power semiconductor component, in particular a bipolar transistor with an insulated gate electrode.

15. Electronics module (1) according to one of claims 13 or 14,
comprising a cooling beam (43) which has recesses (45) for receiving cooling fins (27) of the heat sink (11),
wherein the heat sink (11) is connected via the cooling fins (27) to the recesses (45) of the cooling beam (43).

## Revendications

1. Support (3) d'au moins un composant (5 à 7) électrique, le support (3) comprenant
- un dissipateur (11) de chaleur ayant une surface (31) de dissipateur de chaleur et deux parois (25) latérales opposées s'éloignant de la surface (31) du dissipateur de chaleur,
- deux blocs (13) d'étanchéité s'appliquant à la surface (31) du dissipateur de chaleur à distance l'un de l'autre, qui s'étendent respectivement entre les deux parois (25) latérales et qui s'appliquent à chacune des deux parois (25) latérales, et
- une structure (15) de support, disposée sur la surface (31) du dissipateur de chaleur entre les deux blocs (13) d'étanchéité, du au moins un composant (5 à 7) électrique,
dans lequel le dissipateur (11) de chaleur a une embase (21) et une couche (29) de projection à la flamme constituant la surface (31) du dissipateur de chaleur,
dans lequel l'embase (21) est en aluminium,
dans lequel la couche (29) de projection à la flamme est réalisée sous la forme d'une couche de cuivre,
**caractérisé en ce que**
la couche de cuivre est conjointement avec l'embase (21) fabriquée par coulée continue ou
**en ce que** la couche de cuivre est déposée additivement par projection au gaz froid sur la surface (23) de l'embase.

2. Support (3) suivant la revendication 1, dans lequel chaque bloc (13) d'étanchéité peut être assemblé à coopération de force au dissipateur (11) de chaleur par au moins un vissage (33).

3. Support (3) suivant l'une des revendications précédentes, dans lequel chaque bloc (13) d'étanchéité est assemblé à complémentarité de forme au dissipateur (11) de chaleur par au moins un assemblage à rainure et languette.

4. Support (3) suivant l'une des revendications précédentes, dans lequel, sur au moins un bloc (13) d'étanchéité, est disposée au moins une barre (17) de connexion conductrice de l'électricité pour une connexion de puissance électrique.

5. Support (3) suivant l'une des revendications précédentes, dans lequel les blocs (13) d'étanchéité sont en matière plastique.

6. Support (3) suivant l'une des revendications précédentes, dans lequel au moins l'un des blocs (13) d'étanchéité a, sur une face tournée vers la surface (31) du dissipateur de chaleur, une moulure, en particulier orthogonale aux parois (25) latérales, dans lequel est disposé un dispositif d'étanchéité.

7. Support (3) suivant la revendication 6,
dans lequel le dispositif d'étanchéité comporte une liaison adhésive avec la surface (31) du dissipateur de chaleur et/ou avec le au moins un bloc (13) d'étanchéité.

8. Support (3) suivant l'une des revendications précédentes, dans lequel la structure (15) de support a, à l'écart de la surface (31) du dissipateur de chaleur, un substrat (35) en céramique revêtu d'une structure (37) en cuivre.

9. Support (3) suivant l'une des revendications précédentes, comprenant des contacts (19) de connexion, qui sont disposés sur la structure (15) de support et qui sont éloignés de la structure (15) de support à l'écart de la surface (31) du dissipateur de chaleur.

10. Support (3) suivant la revendication 9, comprenant un couvercle (2), qui peut être assemblé de manière amovible au dissipateur (11) de chaleur et qui a des ouvertures (41) de couvercle pour les contacts (19) de connexion, afin de stabiliser les contacts (19) de connexion.

11. Support (3) suivant la revendication 10, dans lequel le couvercle (2) peut être assemblé au dissipateur (11) de chaleur par au moins un encliquetage (39) et/ou au moins un vissage.

12. Procédé de fabrication d'un support (3) suivant l'une des revendications précédentes, dans lequel
- on fabrique le dissipateur (11) de chaleur par coulée continue ou par coulée continue avec dépôt additif ensuite d'une couche (29) de projection à chaud formant la surface (31) du dissipateur de chaleur,
- on fabrique les blocs (13) d'étanchéité par moulage par injection et
- on dépose la structure (15) de support par brasage ou frittage sur la surface (31) du dissipateur de chaleur.

13. Module (1) électronique, comprenant
- un support (3) suivant l'une des revendications 1 à 11,
- au moins un composant (5 à 7) électrique disposé sur la structure (15) du support (3) et
- une masse (9) de coulée, par exemple une masse de coulée souple à base de silicone, qui recouvre la structure (15) de support et le au moins un composant (5 à 7) électrique.

14. Module (1) électronique suivant la revendication 13, dans lequel au moins un composant (5 à 7) électrique est un composant à semiconducteur de puissance, en particulier à transistor bipolaire à électrode de grille isolée.

15. Module (1) électronique suivant l'une des revendications 13 ou 14, comprenant une barre (43) de refroidissement, qui a des évidements (45) de réception de nervures (27) de refroidissement du dissipateur (11) de chaleur,
dans lequel le dissipateur (11) de chaleur est assemblé aux évidements (45) de la barre (43) de refroidissement par les nervures (27) de refroidissement.
